# EUROPEAN PATENT SPECIFICATION

(11) **EP 3 772 114 B1**
(45) Date of publication and mention of the grant of the patent: **12.06.2024**
(21) Application number: 20188609.0
(22) Date of filing: 30.07.2020
(51) Int. Cl.: H10N 30/00, H10N 30/853, H10N 30/079, H10N 30/076

(54) **PIEZOELECTRIC ELEMENT AND MANUFACTURING METHOD THEREOF**
PIEZOELEKTRISCHES BAUELEMENT UND HERSTELLUNGSVERFAHREN DAFÜR
COMPOSANT PIÉZOÉLECTRIQUE ET SON PROCÉDÉ DE FABRICATION

(30) Priority: 02.08.2019 JP 2019143326
(43) Date of publication of application: 03.02.2021
(73) Proprietor: Sumitomo Chemical Company, Limited, Tokyo 104-8260 (JP)
(72) Inventor: SHIBATA, Kenji, Hitachi-shi, Ibaraki 3191418 (JP); WATANABE, Kazutoshi, Hitachi-shi, Ibaraki 3191418 (JP); KURODA, Toshiaki, Hitachi-shi, Ibaraki 3191418 (JP)
(74) Representative: Vossius & Partner Patentanwälte Rechtsanwälte mbB

(56) References cited:
- EP-A1- 3 364 471
- US-A1- 2010 320 871
- US-A1- 2015 194 592
- US-A1- 2016 172 574

## Description

### TECHNICAL FIELD

The present disclosure relates to a piezoelectric laminate, a piezoelectric element, and a method of manufacturing a piezoelectric laminate.

### BACKGROUND

A piezoelectric material is utilized widely for a functional electronic component such as a sensor and an actuator. Lead-based materials, in particular, PZT-based ferroelectrics represented by a composition formula of Pb(Zr₁₋ₓTiₓ)O₃ are used widely for the piezoelectric material. Since PZT-based piezoelectric material includes lead, it is not preferable from a viewpoint of a pollution prevention and the like. Therefore, potassium sodium niobate (KNN) is suggested as a piezoelectric material not including lead (see patent documents 1 and 2, for example). Recently, it is strongly required to further improve a performance of the piezoelectric material configured by the material not including lead such as KNN.

Patent document 3 relates to a piezoelectric device comprising a piezoelectric film having a columnar structure; and electrodes disposed in contact with the piezoelectric film, wherein the piezoelectric film has a composition containing an element which can substitute Nb and has an oxidation number of 2 or more and less than 5 when oxidized the element being in a proportion of 3.3 mol or less relative to 100 mol of potassium sodium niobate represented by a general formula (K₁₋ₓNaₓ)NbO₃, where 0<x<1.

Patent document 4 concerns a piezoelectric element characterized by comprising a first electrode layer, a second electrode layer, and a piezoelectric layer sandwiched between the first electrode layer and the second electrode layer, wherein the piezoelectric layer is provided with at least one layer, each of a first piezoelectric layer which is a potassium-sodium niobate thin film substantially not containing Mn (manganese) and a second piezoelectric layer which is a potassium-sodium niobate thin film containing Mn.

Patent document 5 describes a laminated substrate with a piezoelectric thin film, comprising a substrate; an electrode film formed on the substrate; and a piezoelectric thin film formed on the electrode film, wherein the piezoelectric thin film is made of an alkali niobium oxide represented by a composition formula of (K₁₋ₓNaₓ)NbO₃ (0 < x < 1), having a perovskite structure, and oriented preferentially in (001) plane direction, and
contains a metallic element selected from a group consisting of Mn and Cu at a concentration of 0.2 at% or more and 0.6 at% or less.

Patent document 6 relates to a piezoelectric thin film element, comprising a substrate; and a piezoelectric thin film formed on the substrate by a sputtering method, with perovskite oxide expressed by (NaₓKᵥLi_{z})NbO₃ (0≦x≦1, 0≦y≦1, 0≦z≦0, 2, x+y+z=1) as a main phase, wherein an absolute value of an internal stress of the piezoelectric thin film is 1.6 GPa or less.

Patent document 1: Japanese Patent Laid Open Publication No.2007-184513 & US 2007/126313 A1
Patent document 2: Japanese Patent Laid Open Publication No.2008-159807 & US 2009/236944 A1
Patent document 3: US 2016/172574 A1
Patent document 4: US 2015/194592 A1
Patent document 5: EP 3 364 471 A1
Patent document 6: US 2010/320871 A1

### SUMMARY

An object of the present disclosure is to further improve an insulation property of a piezoelectric laminate having a piezoelectric film comprised of alkali niobium oxide.

According to the present invention, there is provided a piezoelectric laminate and a manufacturing method thereof according to independent claims 1 and 5, respectively. The present invention furthermore relates to a piezoelectric element as set out in claim 4.

According to the present invention, an insulation property of a piezoelectric laminate having a piezoelectric film comprised of alkali niobium oxide can be further improved.

### BRIEF DESCRIPTION OF THE DRAWINGS

FIG. 1 is a view illustrating an example of a cross-section structure of a piezoelectric laminate according to an embodiment of the present invention.
FIG. 2 is a view illustrating a modified example of the cross-section structure of the piezoelectric laminate according to an embodiment of the present invention.
FIG. 3 is a view illustrating an example of a schematic constitution of a piezoelectric device according to an embodiment of the present invention.

### EMBODIMENTS

### <An embodiment of the present invention>

An embodiment of the present invention will be described hereafter, with reference to the drawings.

### (1) A constitution of a piezoelectric laminate

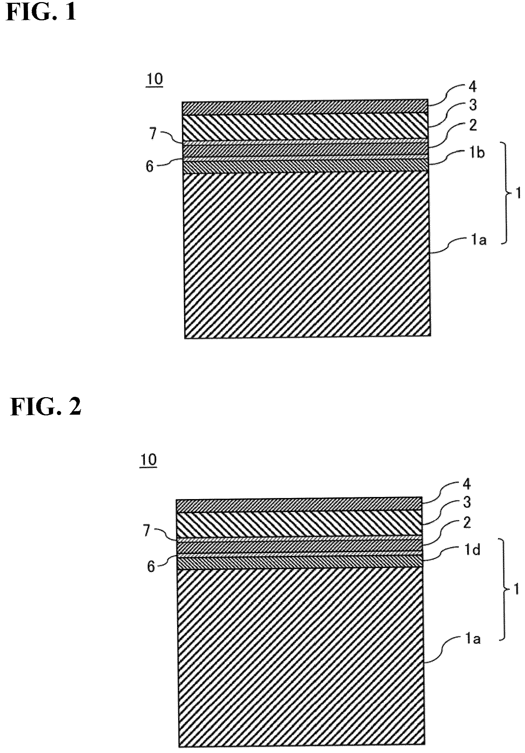

As illustrated in FIG. 1, a laminate (laminated substrate) 10 (also referred to as piezoelectric laminate 10 hereafter) including a piezoelectric film according to the present embodiment includes a substrate 1, a bottom electrode film 2, a piezoelectric film (piezoelectric thin film) 3, and, preferably, a top electrode film 4.

As the substrate 1, a single-crystal silicon (Si) substrate 1a on which a surface oxide film (SiO₂-film) 1b such as a thermal oxide film or a CVD (Chemical Vapor Deposition) oxide film is formed (provided), namely, a Si-substrate having the surface oxide film can be used preferably. Further, as illustrated in FIG. 2, a Si-substrate 1a including an insulating film 1d formed on its surface may also be used as the substrate 1, the insulating film 1d containing an insulating material other than SiO₂. Further, a Si-substrate 1a in which Si-(100) plane or Si-(111) plane, etc., is exposed on a surface thereof, namely, a Si-substrate not having the surface oxide film 1b or the insulating film 1d may also be used as the substrate 1. Further, an SOI (Silicon On Insulator) substrate, a quartz glass (SiO₂) substrate, a gallium arsenide (GaAs) substrate, a sapphire (Al₂O₃) substrate, a metal substrate containing a metal material such as stainless steel (SUS) may also be used as the substrate 1. The single-crystal Si-substrate 1a has a thickness of, for example, 300 to 1000 µm, and the surface oxide film 1b has a thickness of, for example, 1 to 4000 nm.

The bottom electrode film 2 is formed (provided, deposited) on the substrate 1. The bottom electrode film 2 can be comprised, for example, of platinum (Pt). The bottom electrode film 2 is a polycrystalline film (this is also referred to as Pt-film hereafter). Preferably, crystals forming (included in) the Pt-film are preferentially oriented in (111) plane direction with respect to a surface of the substrate 1. Namely, a surface of the Pt-film (a surface which is a base of an LNO-layer 7 described later) is preferably mainly constituted of Pt-(111) plane. The Pt-film can be formed using a method such as a sputtering method or an evaporation method. Instead of Pt, the bottom electrode film 2 may also be comprised of various metals such as gold (Au), ruthenium (Ru), or iridium (Ir), or an alloy mainly composed of the above various metals, etc. An adhesion layer 6 mainly composed of, for example, titanium (Ti), tantalum (Ta), titanium oxide (TiO₂), nickel (Ni), ruthenium oxide (RuO₂), or iridium oxide (IrO₂), etc., may be formed between the substrate 1 and the bottom electrode film 2 in order to enhance an adhesion between them. The adhesion layer 6 can be formed using a method such as a sputtering method or an evaporation method. The bottom electrode film 2 has a thickness of, for example, 100 to 400 nm, and the adhesion layer 6 has a thickness of, for example, 1 to 200 nm.

The piezoelectric film 3 is comprised of alkali niobium oxide which includes potassium (K), sodium (Na), and niobium (Nb), and which is represented by a composition formula of (K₁₋ₓNaₓ)NbO₃. Namely, the piezoelectric film 3 is comprised of potassium sodium niobate (KNN). A coefficient x [= Na/(K+Na)] in the above composition formula is a value in a range of 0 < x < 1. The piezoelectric film 3 is a polycrystalline film of KNN (also referred to as KNN-film 3 hereafter). A crystal structure of KNN is a perovskite structure. The KNN-film 3 can be formed (provided, deposited) using a method such as a sputtering method, a PLD (Pulsed Laser Deposition) method, or a sol-gel method. The KNN-film 3 has a thickness of, for example, 0.5 µm or more and 5 µm or less, preferably 0.5 µm or more and 2 µm or less, and more preferably 0.5 µm or more and less than 1 µm.

Preferably, crystals forming (included in) the KNN-film 3 are preferentially oriented in (001) plane direction with respect to the surface of the substrate 1 (the surface of the Si-substrate 1a when the substrate 1 is, for example, the Si-substrate 1a including the surface oxide film 1b or the insulating film 1d, etc.). Namely, a surface of the KNN-film 3 (a surface which is a base of the top electrode film 4) is preferably mainly constituted of KNN-(001) plane. For example, 80 % or more regions of the surface of the KNN-film 3 are preferably KNN-(001) plane.

More than half of the crystals included in the crystal grain group forming the KNN-film 3 preferably have a columnar structure. Boundaries between the crystals included in the KNN-film 3, namely, (crystal) grain boundaries in the KNN-film 3 preferably penetrate the KNN-film 3 in a thickness direction. For example, the number of the grain boundaries penetrating the KNN-film 3 in the thickness direction is preferably larger than the number of the grain boundaries not penetrating the KNN-film 3 in the thickness direction (for example, the grain boundaries in parallel to a planar direction of the substrate 1).

The KNN-film 3 contains at least one of metallic elements selected from a group consisting of copper (Cu) and manganese (Mn) at a concentration in a range of 0.2 at% or more and 2.0 at% or less. When the KNN-film 3 contains the metallic elements of both Cu and Mn, a total concentration of Cu and Mn is preferably in the above range.

By adding (doping) at least one of Cu or Mn into the KNN-film 3 at the concentration in the above range, a film property of the KNN-film 3 can be improved. For example, an increase of a leakage current can be suppressed, the leakage current being flowed through the KNN-film 3 when applying an electric field to a piezoelectric element 20 (piezoelectric device 30) described later produced by processing the piezoelectric laminate 10 (namely, when applying the electric field to the KNN-film 3). Further, a dielectric constant of the KNN-film 3 can be an appropriate value according to applications of the piezoelectric laminate 10.

Oxygen vacancies (oxygen deficiencies) exist at a prescribed ratio inside the crystals (crystal grains) included in the KNN-film 3 or on the grain boundaries in the KNN-film 3. The above oxygen vacancies on the grain boundaries in the KNN-film 3 sometimes move when applying the electric field to the KNN-film 3, etc. When the oxygen vacancies move and spread over the electrode film (the bottom electrode film 2 or the top electrode film 4), the oxygen vacancies react with the metal included in the electrode film, resulting in causing short-circuit. By adding Cu into the KNN-film 3, Cu makes a pair with the oxygen vacancies on the grain boundaries in the KNN-film 3, namely, Cu on the grain boundaries traps the oxygen vacancies. As a result, the movement of the oxygen vacancies on the grain boundaries in the KNN-film 3 can be suppressed.

Furthermore, by adding Cu into the KNN-film 3 at the concentration in the above range, a resistance to a fluorine-based etching solution (for example, a buffered hydrofluoric acid (BHF) solution including hydrogen fluoride (HF) and ammonium fluoride (NH₄F), at a prescribed concentration respectively) can also be improved, namely, an etching resistance can also be improved. Thereby, a formation of a protect film for protecting an exposed surface of the KNN-film 3 is not required. Namely, the BHF solution can be used as the etching solution with no need to form the protect film. As a result, processes after producing the piezoelectric laminate 10 can be simplified.

When adding Mn instead of Cu into the KNN-film 3, the above effect of suppressing the movement of the oxygen vacancies and the above effect of improving the etching resistance of the KNN-film 3, can be hardly obtained. In this point, adding Cu into the KNN-film 3 is preferable than adding Mn thereinto. Hereafter, the KNN-film 3 (also referred to as Cu-KNN film 3) added with Cu at the concentration in the above prescribed range, will be described.

The top electrode film 4 is formed (provided, deposited) on the Cu-KNN film 3. The top electrode film 4 can be comprised of various metals such as, for example, Pt, Au, aluminum (Al), or Cu, or an alloy of these various metals. The top electrode film 4 can be formed using a method such as a sputtering method, an evaporation method, a plating method, or a metal paste method. The top electrode film 4 does not greatly affect the crystal structure of the KNN-film 3 unlike the bottom electrode film 2. Therefore, a material and a crystal structure of the top electrode film 4, and a method of forming the top electrode film 4 are not particularly limited. An adhesion layer mainly composed of, for example, Ti, Ta, TiO₂, Ni, RuO₂, or IrO₂, etc., may be formed between the KNN-film 3 and the top electrode film 4 in order to enhance an adhesion between them. The top electrode film 4 has a thickness of, for example, 10 to 5000 nm, and the adhesion layer has a thickness of, for example, 1 to 200 nm when forming the adhesion layer.

Conventionally, in the piezoelectric laminate including the substrate 1, the bottom electrode film 2, the Cu-KNN film 3, and the top electrode film 4, the Cu-KNN film 3 is formed directly on the bottom electrode film 2. However, it is found that in such a conventional piezoelectric laminate, a breakdown voltage of the Cu-KNN film 3 is low. Therefore, the present inventors intensively studied on improving the breakdown voltage of the Cu-KNN film 3 in the piezoelectric laminate including the Cu-KNN film 3. After intensive studies by the present inventors, it is found for the first time that by forming a layer (LNO-layer) 7 comprised of lanthanum nickel oxide (LaNiO₃, abbreviated as LNO) directly under the Cu-KNN film 3, the Cu-KNN film 3 has a high breakdown voltage.

The LNO-layer 7 is formed between the bottom electrode film 2 and the Cu-KNN film 3, specifically on the bottom electrode film 2 and directly under the Cu-KNN film 3. The LNO-layer 7 is a single-crystal layer or a polycrystalline layer. A crystal structure of LNO is a perovskite structure. LNO is a material self-oriented easily in (100) plane direction. Preferably, crystals forming (included in) the LNO-layer 7 are preferentially oriented in (100) plane direction with respect to the surface of the substrate 1. Namely, a surface of the LNO-layer 7 (a surface which is a base of the Cu-KNN film 3) is preferably mainly constituted of LNO-(100) plane. By forming the LNO-layer 7 directly on the Pt-film preferentially oriented in (111) plane direction with respect to the substrate 1, the crystals included in the LNO-layer 7 can be preferentially oriented in (100) plane direction with respect to the surface of the substrate 1. The LNO-layer 7 can be formed using a method such as a sputtering method, or an evaporation method.

As described above, the LNO-layer 7 has the surface mainly constituted of (100) plane, and has the same crystal structure as KNN. On the other hand, the bottom electrode film 2, namely the Pt-film has the surface mainly constituted of (111) plane, and has a crystal structure different from KNN. Therefore, the crystals included in the Cu-KNN film 3 can be easily preferentially oriented in (001) plane direction when forming the Cu-KNN film 3 directly on the LNO-layer 7 than when forming the Cu-KNN film 3 directly on the bottom electrode film 2. Particularly, by forming the Cu-KNN film 3 directly on the LNO-layer 7, the crystals included in the Cu-KNN film 3 can be preferentially oriented in (001) plane direction from an initial stage of the film formation (deposition) of the Cu-KNN film 3. Therefore, an orientation of the Cu-KNN film 3, particularly the orientation of the Cu-KNN film 3 in the vicinity of an interface with the LNO-layer 7, can be improved. Thereby, an effective thickness of the Cu-KNN film 3 can be increased. As a result, the Cu-KNN film 3 has a high breakdown voltage of 350 kV/cm or more, preferably 400 kV/cm or more. As described above, by forming the LNO-layer 7 directly under the Cu-KNN film 3, an insulation property of the Cu-KNN film 3 can be improved.

It is known that LNO can be used as a material for forming the electrode film such as the bottom electrode film 2 or the top electrode film 4. Therefore, it is also conceivable that the bottom electrode film 2 is comprised of LNO, and the Cu-KNN film 3 is formed directly thereon (namely, on the bottom electrode film 2 comprised of LNO). However, in this case, a control of an etching process after forming the piezoelectric laminate 10 is sometimes very difficult. Namely, a controllability of the etching process after forming the piezoelectric laminate 10 is sometimes deteriorated. For example, it is sometimes difficult to control an etching rate when performing a wet etching for patterning the Cu-KNN film 3 into a prescribed shape. This is because both KNN and LNO are oxides. Therefore, KNN and LNO have almost the same etching rate for a prescribed etching solution (for example, an etching solution including an alkali aqueous solution of chelating agent, and not including hydrofluoric acid, specifically, an etching solution obtained by mixing ethylenediaminetetraacetic acid (abbreviated as EDTA, 5 g, ~ 0.1 M (mol/L), preferably 0.01 M or more and 0.1 M or less) as the chelating agent, ammonia water (NH₄OH, 29 %, 37 mL), and hydrogen peroxide water (30 %, 125 mL)). As a result, when the bottom electrode film 2 is comprised of LNO, the bottom electrode film 2 is sometimes etched and removed together with the Cu-KNN film 3 during the wet etching of the Cu-KNN film 3. Therefore, when the bottom electrode film 2 is comprised of LNO, precise control of the etching rate is required during patterning of the Cu-KNN film 3.

On the other hand, in the present embodiment, the LNO-layer 7 is formed in addition to the bottom electrode film 2. The LNO-layer 7 is not formed for the purpose of functioning as the electrode film, but is formed for the purpose of improving the orientation of the Cu-KNN film 3, particularly the orientation of the Cu-KNN film 3 from the initial stage of the film formation. Therefore, the LNO-layer 7 may be etched and removed after forming the Cu-KNN film 3. Namely, the LNO-layer 7 may be etched and removed together with the Cu-KNN film 3 during patterning of the Cu-KNN film 3. Further, in the present embodiment, the bottom electrode film 2 is comprised of a material different from LNO. For example, the bottom electrode film 2 is comprised of a material having a different etching rate for the prescribed etching solution from KNN, preferably a material having a lower etching rate for the prescribed etching solution than KNN. Specifically, as described above, the bottom electrode film 2 is comprised of the various metals such as Pt, Au, Ru, or Ir, or the alloy mainly composed of the above various metals, etc. Due to these constitutions of the present embodiment, the deterioration of the controllability of the etching process after forming the piezoelectric laminate 10, can be suppressed while obtaining the above effect of improving the orientation of the Cu-KNN film 3 from the initial stage of the film formation.

According to the present invention, an average grain size of the crystals (crystal grain group) forming (included in) the LNO-layer 7 (also referred to as "average crystal grain size in the LNO-layer 7") is 100 nm or more. The average crystal grain size in the LNO-layer 7 used herein is an average crystal grain size in a cross-section of the LNO-layer 7 in the planar direction of the substrate 1. The average crystal grain size in the LNO-layer 7 can be obtained by analyzing a visual field of an image (for example, SEM image) imaged using a scanning electron microscopy or an image imaged (for example, TEM image) using a transmission electron microscopy. For example, "Image J" manufactured by Wayne Rasband can be used as an image analysis software. The LNO-layer 7 grows while having a surface crystal structure of, for example, the Pt-film which is a base of the LNO-layer 7. Therefore, it becomes easy to make the LNO-layer 7 have the average crystal grain size of 100 nm or more, because the Pt-film has an average crystal grain size of, for example, 100 nm or more.

The Cu-KNN film 3 grows while having a surface crystal structure of the LNO-layer 7 which is the base of the Cu-KNN film 3. Therefore, an average grain size in the crystal grain group included in the Cu-KNN film 3 (also referred to as "average crystal grain size in the Cu-KNN film 3" hereafter) can be large, because the average crystal grain size in the LNO-layer 7 is large. It becomes easy to make the Cu-KNN film 3 have the average crystal grain size of, for example, 100 nm or more, because the LNO-layer 7 has the average crystal grain size of, for example, 100 nm or more. The average crystal grain size in the Cu-KNN film 3 used herein is an average crystal grain size in a cross-section of the Cu-KNN film 3 in the planar direction of the substrate 1. The average crystal grain size in the Cu-KNN film 3 can be obtained by the same analysis as the analysis for the above average crystal grain size in the LNO-layer 7. The grain boundaries in the Cu-KNN film 3 can be reduced, namely, a grain boundary density in the Cu-KNN film 3 can be lowered, because the average crystal grain size in the Cu-KNN film 3 is large.

From a viewpoint of lowering the grain boundary density in the Cu-KNN film 3, the larger average crystal grain size in the Cu-KNN film 3 is preferable. However, when the average crystal grain size in the Cu-KNN film 3 is larger than the thickness of the Cu-KNN film 3, an in-plane uniformity of a piezoelectric property is sometimes deteriorated. Therefore, from a viewpoint of suppressing the deterioration of the in-plane uniformity of the piezoelectric property, the average crystal grain size in the Cu-KNN film 3 is preferably smaller than the thickness of the Cu-KNN film 3. As a result, the LNO-layer 7 preferably has an average crystal grain size that allows the average crystal grain size in the Cu-KNN film 3 to be smaller than the thickness of the Cu-KNN film 3.

The LNO-layer 7 has a thickness of, for example, 10 nm or more, preferably 20 nm or more. The LNO-layer 7 can be a continuous film, because the LNO-layer 7 has the thickness of 10 nm or more. As a result, the above effect of improving the orientation of the Cu-KNN film 3 from the initial stage of the film formation, can be reliably obtained. The LNO-layer 7 can be reliably the continuous film, because the LNO-layer 7 has the thickness of 20 nm or more. As a result, the effect of improving the orientation of the Cu-KNN film 3 can be more reliably obtained. An upper limit in the thickness of the LNO-layer 7 is not particularly limited. However, from a viewpoint of miniaturizing the piezoelectric laminate 10, the LNO-layer 7 preferably has a thickness of, for example, 300 nm or less.

### (2) A constitution of a piezoelectric device

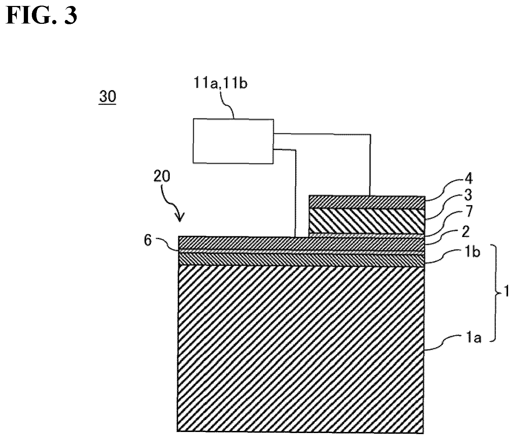

FIG. 3 illustrates a schematic constitution view of a device 30 (also referred to as piezoelectric device 30 hereafter) including the KNN-film 3 according to the present embodiment. The piezoelectric device 30 includes at least an element 20 (an element 20 including the KNN-film 3, and also referred to as piezoelectric element 20 hereafter) obtained by forming the above piezoelectric laminate 10 into a prescribed shape, and a voltage application unit 11a or a voltage detection unit 11b connected to the piezoelectric element 20. The voltage application unit 11a is a means for applying a voltage between the bottom electrode film 2 and the top electrode film 4 (between electrodes), and the voltage detection unit 1 1b is a means for detecting a voltage generated between the bottom electrode film 2 and the top electrode film 4 (between electrodes). Publicly-known various means can be used as the voltage application unit 11a and the voltage detection unit 11b.

By connecting the voltage application unit 11a between the bottom electrode film 2 and the top electrode film 4 of the piezoelectric element 20, the piezoelectric device 30 can function as an actuator. By applying a voltage between the bottom electrode film 2 and the top electrode film 4 using the voltage application unit 11a, the KNN-film 3 can be deformed. Various structures connected to the piezoelectric device 30 can be actuated due to the above deformation motion. In this case, the piezoelectric device 30 can be applied to, for example, a head for an inkjet printer, a MEMS mirror for a scanner, and a vibrator for an ultrasonic generator, etc.

By connecting the voltage detection unit 11b between the bottom electrode film 2 and the top electrode film 4 of the piezoelectric element 20, the piezoelectric device 30 can function as a sensor. When the KNN-film 3 is deformed according to a variation of some physical quantity, a voltage is generated between the bottom electrode film 2 and the top electrode film 4 due to the deformation. By detecting this voltage using the voltage detection unit 11b, the physical quantity applied to the KNN-film 3 can be measured. In this case, the piezoelectric device 30 can be applied to, for example, an angular velocity sensor, an ultrasonic sensor, a pressure sensor, and an acceleration sensor, etc.

### (3) A method of manufacturing a piezoelectric laminate, a piezoelectric element, and a piezoelectric device

A method of manufacturing the above piezoelectric laminate 10, the piezoelectric element 20, and the piezoelectric device 30 will be described hereafter.

First, the substrate 1 is prepared, and the adhesion layer 6 (Ti-layer), the bottom electrode film 2 (Pt-film), and the LNO-layer 7 are formed in this order on any one of main surfaces of the substrate 1 using, for example, the sputtering method. It is also acceptable to prepare the substrate 1 on which the adhesion layer 6, the bottom electrode film 2, and the LNO-layer 7 are formed in advance on any one of its main surfaces.

For example, the following conditions are given as the conditions for forming the adhesion layer 6.
Temperature (substrate temperature): 100 °C or more and 500 °C or less, preferably 200 °C or more and 400 °C or less
RF power: 1000 W or more and 1500 W or less, preferably 1100 W or more and 1300 W or less
Atmosphere: Argon (Ar) gas atmosphere
Atmosphere pressure: 0.1 Pa or more and 0.5 Pa or less, preferably 0.2 Pa or more and 0.4 Pa or less
Time: 30 seconds or more and 3 minutes or less, preferably 30 seconds or more and 2 minutes or less

For example, the following conditions are given as the conditions for forming the bottom electrode film 2.
Deposition temperature (substrate temperature): 100 °C or more and 500 °C or less, preferably 200 °C or more and 400 °C or less
RF power: 1000 W or more and 1500 W or less, preferably 1100 W or more and 1300 W or less
Deposition atmosphere: Ar-gas atmosphere
Atmosphere pressure: 0.1 Pa or more and 0.5 Pa or less, preferably 0.2 Pa or more and 0.4 Pa or less
Deposition time: 3 minutes or more and 10 minutes or less, preferably 4 minutes or more and 7 minutes or less

For example, the following conditions are given as the conditions for forming the LNO-layer 7.
Temperature (substrate temperature): 100 °C or more and 500 °C or less, preferably 200 °C or more and 400 °C or less
RF power: 1000 W or more and 1500 W or less, preferably 1100 W or more and 1300 W or less
Atmosphere: Ar-gas atmosphere
Atmosphere pressure: 0.1 Pa or more and 0.5 Pa or less, preferably 0.2 Pa or more and 0.4 Pa or less
Time: 30 seconds or more and 3 minutes or less, preferably 30 seconds or more and 1 minute or less

Next, the Cu-KNN film 3 is formed on the LNO-layer 7. When the Cu-KNN film 3 is formed using, for example, the sputtering method, a composition ratio of the Cu-KNN film 3 can be adjusted by controlling, for example, a composition of a target material used during sputtering. The target material can be produced by mixing and baking K₂CO₃-powder, Na₂CO₃-powder, Nb₂O₅-powder, and CuO-powder, etc. The composition of the target material can be controlled by adjusting a mixed ratio of K₂CO₃-powder, Na₂CO₃-powder, Nb₂O₅-powder, and CuO-powder. The KNN-film 3 containing Cu at the above concentration can be formed using (K₁₋ₓNaₓ)NbO₃-sintered ceramics target material containing Cu at a concentration of, for example, 0.2 at% or more and 2.0 at% or less.

For example, the following conditions are given as the conditions for forming the KNN-film 3.
Deposition temperature (substrate temperature): 500 °C or more and 700 °C or less, preferably 550 °C or more and 650 °C or less
RF power: 2000 W or more and 2400 W or less, preferably 2100 W or more and 2300 W or less
Deposition atmosphere: Ar-gas + oxygen (O₂) gas atmosphere
Atmosphere pressure: 0.2 Pa or more and 0.5 Pa or less, preferably 0.2 Pa or more and 0.4 Pa or less
Partial pressure of Ar-gas to O₂-gas (partial pressure ratio of Ar/O₂): 30/1 to 20/1, preferably 27/1 to 23/1
Deposition rate: 0.5 µm/h or more and 2 µm/h or less, preferably 0.5 µm/h or
more and 1.5 µm/h or less

Then, the top electrode film 4 is formed on the KNN-film 3 using, for example, the sputtering method. Conditions for forming the top electrode film 4 may be the same conditions for forming the bottom electrode film 2 as described above. Thereby, the piezoelectric laminate 10 including the substrate 1, the bottom electrode film 2, the LNO-layer 7, the Cu-KNN film 3, and the top electrode film 4 can be obtained, for example, as illustrated in FIG. 1.

Then, by forming this piezoelectric laminate 10 into a prescribed shape using an etching, etc., the piezoelectric element 20 is obtained as illustrated in FIG. 3, and by connecting the voltage application unit 11a or the voltage detection unit 11b to the piezoelectric element 20, the piezoelectric device 30 is obtained.

### (4) Effect obtained by the present embodiment

According to the present embodiment, one or more of the following effects can be obtained.

(a) By forming the LNO-layer 7 directly under the Cu-KNN film 3, particularly the orientation of the Cu-KNN film 3 can be improved from the initial stage of the film formation. Therefore, the effective thickness of the Cu-KNN film 3 can be increased. As a result, the Cu-KNN film 3 has the high breakdown voltage of 350 kV/cm or more, preferably 400 kV/cm or more. Thereby, a higher electric field can be applied to the Cu-KNN film 3, and therefore a performance of the piezoelectric device 30 such as a sensor and an actuator produced by processing the piezoelectric laminate 10 can be improved, and a high versatility of the piezoelectric device 30 can be realized.

The present inventors have confirmed that the above effect of improving the orientation of the Cu-KNN film 3 from the initial stage of the film formation can be obtained when forming the LNO-layer 7 directly under the Cu-KNN film 3, and cannot be obtained when forming the LNO-layer 7 directly under the KNN-film (undoped KNN-film) not added with Cu.

Further, it is also conceivable that instead of the LNO-layer 7, a layer (SRO-layer) comprised of strontium ruthenium oxide (SrRuOs, abbreviated as SRO) and having a surface mainly constituted of (100) plane, is formed directly under the Cu-KNN film 3. Similarly to LNO, SRO is a material self-oriented easily in (100) plane direction, and has the same crystal structure (perovskite structure) as KNN. However, the present inventors have confirmed that when forming the SRO-layer directly under the Cu-KNN film 3, the above effect of improving the orientation of the Cu-KNN film 3 from the initial stage of the film formation cannot be obtained, and the breakdown voltage of the Cu-KNN film 3 cannot be improved.

(b) By forming the LNO-layer 7 directly under the Cu-KNN film 3, the orientation of the Cu-KNN film 3 can be improved from the initial stage of the film formation. Therefore, even when the thickness of the Cu-KNN film 3 decreases, the Cu-KNN film 3 has the high breakdown voltage. For example, even when the thickness of the Cu-KNN film 3 is 2 µm or less, preferably less than 1 µm, the Cu-KNN film 3 has the high breakdown voltage of 350 kV/cm or more. Therefore, according to the present disclosure, the piezoelectric device 30 can be miniaturized without lowering the performance of the piezoelectric device 30.

(c) By forming the LNO-layer 7 directly under the Cu-KNN film 3, the orientation of the Cu-KNN film 3 can be improved. Thereby, the grain boundary density in the Cu-KNN film 3 can be lowered. A leak path is formed on the grain boundaries in the Cu-KNN film 3, the leak path being a factor that causes a dielectric breakdown when applying the electric field to the Cu-KNN film 3. By lowering the grain boundary density in the Cu-KNN film 3, namely, by reducing the grain boundaries in the Cu-KNN film 3, the leak path is hardly formed in the Cu-KNN film 3. As a result, the breakdown voltage of the Cu-KNN film 3 can be reliably improved.

(d) By improving the orientation of the Cu-KNN film 3, the oxygen vacancies existing in the Cu-KNN film 3 can be reduced. Of the oxygen vacancies existing in the Cu-KNN film 3, particularly the oxygen vacancies on the grain boundaries may be a factor that the leak path is formed in the Cu-KNN film 3. By reducing the oxygen vacancies existing in the Cu-KNN film 3, the oxygen vacancies on the grain boundaries in the Cu-KNN film 3 are also be reduced. Therefore, the leak path is further hardly formed in the Cu-KNN film 3, and the breakdown voltage of the Cu-KNN film 3 can be more reliably improved.

(e) The average crystal grain size in the Cu-KNN film 3 can be large, because the average crystal grain size in the LNO-layer 7 is large. As a result, the grain boundary density in the Cu-KNN film 3 can be further lowered. Thereby, the leak path is further hardly formed in the Cu-KNN film 3, and the breakdown voltage of the Cu-KNN film 3 can be more reliably improved.

(f) At least the above effect of improving the orientation of the Cu-KNN film 3 from the initial stage of the film formation, can be reliably obtained, because the LNO-layer 7 has the thickness of 10 nm or more.

(g) In the present embodiment, in addition to the bottom electrode film 2, the LNO-layer 7 not functioning as the electrode film is formed. Further, the bottom electrode film 2 is comprised of a material different from LNO. Thereby, the deterioration of the controllability of the etching process after forming the piezoelectric laminate 10 can be suppressed while obtaining the above effect of increasing the effective thickness of the Cu-KNN film 3.

(h) By adding Cu into the KNN-film 3, the movement of the oxygen vacancies on the grain boundaries can be suppressed. As a result, the oxygen vacancies in the Cu-KNN film 3 hardly spread over the electrode film, and an occurrence of the dielectric breakdown of the Cu-KNN film 3 can be suppressed. Namely, the breakdown voltage of the Cu-KNN film 3 can be more improved.

(i) The present inventors have confirmed that in the KNN-film (Mn-doped KNN-film) added with Mn as well, similarly to the Cu-KNN film 3, the Mn-doped KNN-film has the high breakdown voltage when forming the LNO-layer directly under the Mn-doped KNN-film than when not forming the LNO-layer directly under the Mn-doped KNN-film. However, in a point of obtaining the above effect of suppressing the movement of the oxygen vacancies and the effect of improving the etching resistance of the KNN-film 3, adding Cu into the KNN-film 3 is preferable than adding Mn thereinto.

### (5) Modified examples

The present embodiment is not limited to the abovementioned embodiment, and can be modified as the following modified examples. Further, these modified examples can be arbitrarily combined.

### (Modified example 1)

The Cu-KNN film 3 may contain an element such as lithium (Li), Ta, antimony (Sb) other than K, Na, Nb, Cu, and Mn in a range of not impairing the above effect of lowering the grain boundary density in the KNN-film 3, for example, in a range of 5 at% or less (when adding a plurality of the above elements, a total concentration is 5 at% or less).

### (Modified example 2)

In addition to Cu or Mn, or instead of Cu or Mn, the KNN-film 3 may contain other metallic elements obtained an effect equivalent to Cu or Mn at a concentration where the dielectric constant of the KNN-film 3 can be appropriate value, while obtaining the above effect of lowering the grain boundary density in the KNN-film 3. In this case as well, similar effects as the above embodiment and modified example can be obtained.

### (Modified example 3)

The substrate 1 may be removed from the piezoelectric laminate 10 when forming the above piezoelectric laminate 10 into the piezoelectric element 20, as long as the piezoelectric device 30 produced using the piezoelectric laminate 10 (piezoelectric element 20) is applied to desired applications such as a sensor or an actuator.

### Examples

Explanation will be given for an experimental result supporting the effects of the above embodiment hereafter.

In samples 1 to 6, a Si-substrate having a surface of (100) plane direction, a thickness of 610 µm, a diameter of 15.24 cm (6 inches), and a thermal oxide film (thickness: 200 nm) formed on its surface, was prepared as a substrate. Then, a piezoelectric laminate was produced by forming a Ti-layer (thickness: 2 nm) as an adhesion layer, a Pt-film (preferentially oriented in (111) plane direction with respect to a surface of the substrate, thickness: 200 nm) as a bottom electrode film, an LNO-layer (thickness: thicknesses shown in Table 1 described later, average crystal grain size: values shown in Table 1), and a KNN-film (preferentially oriented in (001) plane direction with respect to the surface of the substrate, thickness: thicknesses shown in Table 1) in this order on the thermal oxide film of the substrate.

The Ti-layer was formed under the following conditions, using an RF magnetron sputtering method.
Temperature: 300 °C
RF power: 1200 W
Gas: Ar-gas
Pressure in Ar-gas atmosphere: 0.3 Pa
Time: 1 minute

The Pt-film was formed under the following conditions, using the RF magnetron sputtering method.
Deposition temperature: a prescribed temperature of 100 °C or more and 500 °C or less RF power: 1200 W
Gas: Ar-gas
Pressure in Ar-gas atmosphere: 0.3 Pa
Time: 5 minutes

Here, the LNO-layer grows while having a surface crystal structure of the Pt-film which is a base of the LNO-layer. Therefore, the average crystal grain size in the LNO-layer can be in a prescribed range, because the average crystal grain size in the Pt-film is in a prescribed range. The average crystal grain size in the Pt-film was adjusted by adjusting the deposition temperature of the Pt-film. The average crystal grain size in the Pt-film tends to increase as the deposition temperature is high.

The LNO-layer was formed under the following conditions, using the RF magnetron sputtering method.
Temperature: 300 °C
RF power: 1200 W
Gas: Ar-gas
Pressure in Ar-gas atmosphere: 0.3 Pa
Time: 1 minute

The KNN-film was formed under the following conditions, using the RF magnetron sputtering method. A deposition time was appropriately changed in accordance with the thickness of the KNN-film to be formed.
Temperature: 600 °C
RF power: 2200 W
Gas: Ar + O₂ mixed gas
Pressure in Ar + O₂ mixed gas atmosphere: 0.3 Pa
Partial pressure of Ar-gas to O₂-gas (partial pressure ratio of Ar/O₂): 25/1
Deposition rate: 1 µm/h

(K₁₋ₓNaₓ)NbO₃ sintered ceramics having a composition of (K+Na)/Nb = 0.8 to 1.2 and Na/(K+Na) = 0.4 to 0.7, and containing Cu at a concentration of, respectively, 0.2 at%, 0.5 at%, 1.0 at%, 1.5 at%, and 2.0 at%, was used as a sputtering target material for forming the KNN-film added with Cu. The target material was formed as follows: K₂CO₃-powder, Na₂CO₃-powder, Nb₂O₅-powder, and CuO-powder were mixed for 24 hours using a ball mill, the mixture was provisionally burned at 850 °C for 10 hours, then pulverized using again the ball mill, and molded under a pressure of 200 MPa, and thereafter burned at 1080 °C. The composition of the target material was controlled by adjusting a mixed ratio of K₂CO₃-powder, Na₂CO₃-powder, Nb₂O₅-powder, and CuO-powder, and measured by EDX (energy dispersive X-ray spectrometry) before performing deposition.

In sample 7, the piezoelectric laminate was produced in the same manner as in the sample 2, except that an SRO-layer (thickness: 10nm, an average crystal grain size: 100 nm) was formed instead of forming the LNO-layer, the value of the thickness of the KNN-film was 3 µm, and the value of the Cu-concentration in the KNN-film was 0.5 at%

In samples 8 to 11, the piezoelectric laminates were produced in the same manner as in the above samples 1 to 6, except that the LNO-layer was not formed, and the values of the thickness of the KNN-film and the Cu-concentration in the KNN-film were shown in Table 1 described later

**[Table 1]**

| Sample | LNO-layer I SRO-layer | | | KNN-film | | withstand voltage (kV/cm) |
|---|---|---|---|---|---|---|
| | layer type | thickness | average crystal grain size | thickness | Cu-concentration | |
| 1 | LNO-layer | 20 nm | 200 nm | 3 µm | 0.2 at% | 450 |
| 2 | LNO-layer | 10 nm | 100 nm | 2 µm | 1.0 at% | 375 |
| 3 | LNO-layer | 10 nm | 90 nm | 2 µm | 1.0 at% | 350 |
| 4 | LNO-layer | 9 nm | 100 nm | 2 µm | 1.5 at% | 350 |
| 5 | LNO-layer | 10 nm | 100 nm | 1 µm | 2.0 at% | 400 |
| 6 | LNO-layer | 10 nm | 100 nm | 0.5 µm | 0.2 at% | 400 |
| 7 | SRO-layer | 10 nm | 100 nm | 3 µm | 0.5 at% | 200 |
| 8 | - | - | - | 3 µm | 0.5 at% | 250 |
| 9 | - | - | - | 2 µm | 2.0 at% | 225 |
| 10 | - | - | - | 1 µm | 1.0 at% | 200 |
| 11 | - | - | - | 0.5 µm | 0.2 at% | 200 |

### (Evaluation for breakdown voltage)

The breakdown voltages of the samples 1 to 11 were measured. These measurement results are shown in Table 1. As shown in Table 1, it is confirmed that the KNN-film has the high breakdown voltage of 350 kV/cm or more, because the LNO-layer is formed on the bottom electrode film and directly under the KNN-film. Further, it is confirmed that by forming the LNO-layer, the KNN-film has the high breakdown voltage of 350 kV/cm or more, even when the thickness of the KNN-film decreases, namely, even when the thickness of the KNN-film is 2 µm or less. Further, it is confirmed that the higher the Cu-concentration in the KNN-film, the higher the breakdown voltage of the KNN-film. Furthermore, it is confirmed that the KNN-film has the further high breakdown voltage, because the average crystal grain size in the LNO-layer is large. Further, it is confirmed that when forming the SRO-layer instead of the LNO-layer, the breakdown voltage of the KNN-film cannot be improved.

The following are preferred features of the piezoelectric laminate of the present invention:
- the piezoelectric film has a breakdown voltage of 400 kV/cm or more;
- the piezoelectric film has a thickness of 0.5 µm or more and 5 µm or less, preferably 0.5 µm or more and 2 µm or less, and more preferably 0.5 µm or more and less than 1 µm;
- the layer comprised of lanthanum nickel oxide has a thickness of 10 nm or more;
- the electrode film is comprised of a material different from lanthanum nickel oxide;
- the electrode film is comprised of a material having a lower etching rate for a prescribed etching solution than lanthanum nickel oxide. The prescribed etching solution is an etching solution including an alkali aqueous solution of chelating agent, and not including hydrofluoric acid. For example, the prescribed etching solution is an etching solution obtained by mixing ethylenediaminetetraacetic acid, ammonia water, and hydrogen peroxide water.
- the metallic element is Cu.

In the piezoelectric element (piezoelectric device), the piezoelectric film preferably has a breakdown voltage of 400 kV/cm or more.

In the method of manufacturing a piezoelectric laminate, the piezoelectric film preferably has a breakdown voltage of 400 kV/cm or more.

### DESCRIPTION OF SIGNS AND NUMERALS

- 1: Substrate
- 2: Electrode film (bottom electrode film)
- 3: Piezoelectric film
- 7: Layer comprised of lanthanum nickel oxide (LNO-layer)
- 10: Piezoelectric laminate
- 20: Piezoelectric element

## Claims

1. A piezoelectric laminate (10), comprising:
a substrate (1);
an electrode film (2) formed on the substrate (1);
a layer (7) comprised of lanthanum nickel oxide and formed on the electrode film (2); and
a piezoelectric film (3) formed on the layer (7) comprised of lanthanum nickel oxide, comprised of alkali niobium oxide of a perovskite structure represented by a composition formula of (K₁₋ₓNaₓ)NbO₃ with 0 < x < 1 and containing a metallic element
selected from a group consisting of Cu and Mn at a concentration of 0.2 at% or more and 2.0 at% or less,
**characterised in that**
the piezoelectric film (3) has a breakdown voltage of 350 kV/cm or more and
an average grain size of crystals included in the layer (7) comprised of lanthanum nickel oxide is 100 nm or more.

2. The piezoelectric laminate (10) according to claim 1, wherein the piezoelectric film (3) has a thickness of 0.5 µm or more and 5 µm or less.

3. The piezoelectric laminate (10) according to claim 1 or 2, wherein the electrode film (2) is comprised of a material different from lanthanum nickel oxide.

4. A piezoelectric element (20), comprising:
the piezoelectric laminate (10) as defined in any one of claims 1 to 3, wherein the electrode film (2) formed on the substrate (1) is referred to as a bottom electrode film and a top electrode film (4) is formed on the piezoelectric film (3).

5. A method of manufacturing a piezoelectric laminate (10), comprising:
forming an electrode film (2) on a substrate (1);
forming a layer (7) comprised of lanthanum nickel oxide on the electrode film (2); and
forming a piezoelectric film (3) comprised of alkali niobium oxide of a perovskite structure represented by a composition formula of (K₁₋ₓNaₓ)NbO₃ with 0 < x < 1 and containing a metallic element selected from a group consisting of Cu and Mn at a concentration of 0.2 at% or more and 2.0 at% or less, on the layer (7) comprised of lanthanum nickel oxide,
**characterised in that** the piezoelectric film (3) has a breakdown voltage of 350 kV/cm or more and an average grain size of crystals included in the layer (7) comprised of lanthanum nickel oxide is 100 nm or more.

## Patentansprüche

1. Ein piezoelektrisches Laminat (10), umfassend:
ein Substrat (1);
einen Elektrodenfilm (2), der auf dem Substrat (1) ausgebildet ist;
eine Schicht (7), die aus Lanthan-Nickel-Oxid besteht und auf dem Elektrodenfilm (2) ausgebildet ist; und
einen piezoelektrischen Film (3), der auf der aus Lanthan-Nickel-Oxid bestehenden Schicht (7) ausgebildet ist, aus Alkali-Nioboxid mit einer Perowskit-Struktur besteht, die durch eine Zusammensetzungsformel (K₁₋ₓNaₓ)NbO₃ dargestellt ist, wobei 0 < x < 1 ist, und der ein metallisches Element, ausgewählt aus einer Gruppe bestehend aus Cu und Mn, in einer Konzentration von 0,2 Atom-% oder mehr und 2,0 Atom% oder weniger enthält,
**dadurch gekennzeichnet, dass** der piezoelektrische Film (3) eine Durchbruchspannung von 350 kV/cm oder mehr aufweist und
eine mittlere Korngröße von Kristallen, die in der aus Lanthan-Nickel-Oxid bestehenden Schicht (7) enthalten sind, 100 nm oder mehr beträgt.

2. Das piezoelektrische Laminat (10) nach Anspruch 1, wobei der piezoelektrische Film (3) eine Dicke von 0,5 µm oder mehr und 5 µm oder weniger aufweist.

3. Das piezoelektrische Laminat (10) nach Anspruch 1 oder 2, wobei der Elektrodenfilm (2) aus einem von Lanthan-Nickel-Oxid verschiedenen Material besteht.

4. Ein piezoelektrisches Element (20), umfassend:
das piezoelektrische Laminat (10) wie in einem der Ansprüche 1 bis 3 definiert, wobei der auf dem Substrat (1) ausgebildete Elektrodenfilm (2) als unterer Elektrodenfilm bezeichnet wird und ein oberer Elektrodenfilm (4) auf dem piezoelektrischen Film (3) ausgebildet ist.

5. Ein Verfahren zur Herstellung eines piezoelektrischen Laminats (10), umfassend:
Ausbilden eines Elektrodenfilms (2) auf einem Substrat (1);
Ausbilden einer aus Lanthan-Nickel-Oxid bestehenden Schicht (7) auf dem Elektrodenfilm (2); und
Ausbilden eines piezoelektrischen Films (3), der aus Alkali-Nioboxid mit einer Perowskit-Struktur besteht, die durch eine Zusammensetzungsformel (K₁₋ₓNaₓ)NbO₃ dargestellt ist, wobei 0 < x < 1 ist, der ein metallisches Element, ausgewählt aus einer Gruppe bestehend aus Cu und Mn, in einer Konzentration von 0,2 Atom-% oder mehr und 2,0 Atom% oder weniger auf der aus Lanthan-Nickel-Oxid bestehenden Schicht (7) enthält, **dadurch gekennzeichnet, dass** der piezoelektrische Film (3) eine Durchbruchspannung von 350 kV/cm oder mehr aufweist und eine mittlere Korngröße von Kristallen, die in der aus Lanthan-Nickel-Oxid bestehenden Schicht (7) enthalten sind, 100 nm oder mehr beträgt.

## Revendications

1. Stratifié piézoélectrique (10), comprenant :
un substrat (1) ;
un film d'électrode (2) formé sur le substrat (1) ;
une couche (7) composée d'oxyde de nickel lanthane et formée sur le film d'électrode (2) ; et
un film piézoélectrique (3) formé sur la couche (7) composée d'oxyde de nickel lanthane, composé d'oxyde de niobium d'alcalin d'une structure pérovskite représentée par une formule de composition (K₁₋ₓNaₓ)NbO₃ avec 0 < x < 1
et contenant un élément métallique choisi dans un groupe constitué de Cu et de Mn à une concentration de 0,2 % atomique ou plus et 2,0 % atomique ou moins,
**caractérisé en ce que**
le film piézoélectrique (3) a une tension de claquage de 350 kV/cm ou plus et la taille moyenne de grain des cristaux compris dans la couche (7) composée d'oxyde de nickel lanthane est de 100 nm ou plus.

2. Stratifié piézoélectrique (10) selon la revendication 1, dans lequel le film piézoélectrique (3) a une épaisseur de 0,5 µm ou plus et de 5 µm ou moins.

3. Stratifié piézoélectrique (10) selon la revendication 1 ou 2, dans lequel le film d'électrode (2) est composé d'un matériau différent de l'oxyde de nickel lanthane.

4. Élément piézoélectrique (20), comprenant :
le stratifié piézoélectrique (10) tel que défini dans l'une quelconque des revendications 1 à 3, dans lequel le film d'électrode (2) formé sur le substrat (1) est appelé film d'électrode inférieur et un film d'électrode supérieur (4) est formé sur le film piézoélectrique (3).

5. Méthode de fabrication d'un stratifié piézoélectrique (10), comprenant :
la formation d'un film d'électrode (2) sur un substrat (1) ;
la formation d'une couche (7) composée d'oxyde de nickel lanthane sur le film d'électrode (2) ; et
la formation d'un film piézoélectrique (3) composé d'oxyde de niobium d'alcalin d'une structure pérovskite représentée par une formule de composition (K₁₋ₓNaₓ)NbO₃ avec 0 < x < 1 et
contenant un élément métallique choisi dans un groupe constitué de Cu et de Mn à une concentration de 0,2 % atomique ou plus et 2,0 % atomique ou moins,
sur la couche (7) composée d'oxyde de nickel lanthane,
**caractérisée en ce que**
le film piézoélectrique (3) a une tension de claquage de 350 kV/cm ou plus et la taille moyenne de grain des cristaux compris dans la couche (7) composée d'oxyde de nickel lanthane est de 100 nm ou plus.
